(19) Europäisches Patentamt
European Patent Office
Office européen des brevets

(11) EP 0 692 740 B1

(12) **FASCICULE DE BREVET EUROPEEN**

(45) Date de publication et mention de la délivrance du brevet:
**15.03.2000 Bulletin 2000/11**

(51) Int Cl.$^7$: **G03F 7/00**

(21) Numéro de dépôt: **95401654.9**

(22) Date de dépôt: **07.07.1995**

(54) **Procédé et dispositif de fabrication d'un composant optique**

Verfahren und Vorrichtung zum Herstellen eines optischen Bauelements

Process and apparatus for the manufacture of an optical component

(84) Etats contractants désignés:
**DE GB**

(30) Priorité: **11.07.1994 FR 9408558**

(43) Date de publication de la demande:
**17.01.1996 Bulletin 1996/03**

(73) Titulaire: **INSTRUMENTS S.A.**
**F-75001 Paris (FR)**

(72) Inventeurs:
- **Andre, Jean-Claude**
  **F-54000 Nancy (FR)**
- **Lougnot, Daniel**
  **F-68200 Mulhouse (FR)**
- **Belin, Chantal**
  **F-68200 Mulhouse (FR)**
- **Ballandras, Sylvain**
  **F-25720 Avanne-Aveney (FR)**
- **Zissi, Sofia**
  **F-54000 Nancy (FR)**

(74) Mandataire: **Michelet, Alain et al**
**Cabinet Harlé et Phélip**
**7, rue de Madrid**
**75008 Paris (FR)**

(56) Documents cités:
**EP-A- 0 526 284**
**US-A- 3 864 130**
**US-A- 5 137 801**

- **P. HARIHARAN 'Optical holography: Principles, techniques and applications', 13 Mai 1986, CAMBRIDGE UNIVERSITY PRESS, CAMBRIDGE GB * page 181 - page 185 ***
- **JOURNAL DE PHYSIQUE III, vol. 3, no. 7, 1993 PARIS FR, pages 1445-1460, XP 000372610 C. CARR ET AL. 'Photopolymers for holographic recording: from standard to self-processing materials'**
- **APPLIED OPTICS, vol. 14, no. 2, Février 1975 NEW YORK US, page 378 SHUNGO SUGAWARA ET AL. 'Holographic Recording by Dye-Sensitized Photopolymerization of Acrylamide'**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 0 692 740 B1

Printed by Jouve, 75001 PARIS (FR)

## Description

La présente invention concerne la fabrication d'un composant optique qui peut être utilisé dans un appareil optique en raison de son aptitude à modifier les propriétés d'un faisceau lumineux, ou encore constituer un support de stockage d'informations.

On connaît de nombreux matériaux photosensibles dont les propriétés, épaisseur, indice de réfraction, capacité à absorber la lumière, propriétés magnétiques,... sont modifiées, éventuellement de manière permanente par l'action de la lumière.

Il est connu que de tels matériaux peuvent être utilisés pour la réalisation de composants optiques, ou pour le stockage d'informations.

A titre de documents illustrant l'état de la technique, on peut, par exemple, citer les brevets EP-0.374.875, US-3.658.526 et US-4.917.977, ainsi que les articles de David F. EATON intitulé "Dye Sensitized Photopolymerization" dans "Advanced Photochemistry" 18, 427 (1976) et de D. J. LOUGNOT intitulé "Les photopolymères" pages 245 à 303 dans "Technique d'utilisation des photons" JC ANDRE, AB VANNES, Collection Electra, EDF, 1992.

Toutefois, la précision de réalisation de tels composants ou la densité d'informations stockables est limitée par le diamètre du faisceau de lumière utilisé pour la sensibilisation.

On a amélioré ces performances en utilisant des sources stigmatiques, telles que le laser, et en recourant à des longueurs d'onde de plus en plus courtes. Toutefois, ces améliorations des performances trouvent vite leurs limites et entraînent un coût de mise en oeuvre de plus en plus élevé.

Le but de l'invention est de dépasser ces limites en proposant un procédé et un dispositif de fabrication d'un composant optique fondés sur une technique de photopolymérisation complètement différente de celles utilisées jusqu'à présent.

En effet, il était admis jusqu'à présent que la sensibilisation d'une couche photosensible nécessitait une pénétration des rayons lumineux à l'intérieur de la couche. C'est la raison pour laquelle le faisceau lumineux de sensibilisation était généralement dirigé perpendiculairement à la couche photosensible, de manière à faciliter sa pénétration.

Au contraire, selon le procédé de l'invention, le milieu photosensible reçoit le faisceau lumineux de sensibilisation par une interface éclairée selon une incidence assurant une réflexion totale et donc, la formation d'une zone d'évanescence.

Le brevet US-A-3.864.130 concerne un procédé pour la production de circuits optiques intégrés.

Dans ce procédé, un matériau sensible au rayonnement est exposé à des ondes de surface électromagnétiques, de préférence par réflexion totale. Le matériau sensible au rayonnement est disposé sur un support dans une cellule complètement remplie d'un milieu liquide à très haut indice de réfraction. On envoie une onde plane monochromatique à travers ce milieu liquide.

La présente invention concerne un procédé de fabrication d'un composant optique permettant un bon contrôle de l'épaisseur de polymère déposé, ainsi qu'un dispositif de fabrication d'un composant optique particulièrement adapté à ce procédé.

A cet effet, l'invention concerne un procédé de fabrication d'un composant optique conforme à la revendication 1.

Selon différents modes de réalisation préférés de l'invention :

- la substance photopolymérisable déposée sur le substrat forme, après polymérisation, une couche d'épaisseur comprise entre 0,01 et 5 micromètres ;
- cette substance photopolymérisable contient des molécules susceptibles de polymériser sous l'effet d'un amorçage par des radicaux libres ou des cations et une substance capable sous l'effet de l'éclairement de générer transitoirement ces radicaux libres ou cations ;
- lors de l'éclairement de la substance photopolymérisable, le faisceau lumineux possède une répartition d'amplitude obtenue par une technique interférométrique ;
- lors de l'éclairement de la substance photopolymérisable, le faisceau lumineux est modulé spatialement, en amont de celle-ci par tout moyen approprié tel que, par exemple, un masque ;
- lors de l'éclairement de la substance photopolymérisable, l'image du masque est formée dans la zone d'évanescence ;
- le masque est une valve à cristaux liquides ;
- le substrat est en matériau vitreux d'indice $n_1 > 1{,}35$ ;
- les molécules susceptibles de polymériser ; appartiennent, par exemple, à l'ensemble formé par les mono ou polyesters acryliques ou méthacryliques de polyols ;
- la substance capable de générer transitoirement des radicaux libres ou des cations est un mélange de deux types de molécules utilisées en conjonction telle que, par exemple et de façon non limitative, la benzophénone et ses dérivés, la diéthanolamine, l'acétophénone et ses dérivés, la diméthyléthanolamine, ou tout autre système connu

de l'homme de l'art comme système amorceur photorédox ou oxydo réductif ;

- la substance capable de générer transitoirement des radicaux libres ou des cations comporte un colorant sensibilisateur ;
- le colorant sensibilisateur appartient, par exemple et de façon non limitative, à l'ensemble formé par l'éosine, l'érythrosine, le rose Bengale, le phénosafranine, le bleu de méthylène, la thionine, l'hexaméthylindo ricarbocyanine ;
- la substance capable de générer transitoirement des radicaux libres ou des cations appartient à l'ensemble formé par les éthers de benzoïne, les dérivés de phénylacétophénone et les acylphosphines oxydes et leurs dérivés ;
- le composant optique assure le stockage d'information codée optiquement.

L'invention concerne également un dispositif de fabrication d'un composant optique comprenant :

des moyens d'éclairage par un faisceau lumineux,
des moyens de mise en forme tels que, par exemple, le filtrage spatial du faisceau,

caractérisé en ce qu'il comporte un statif destiné à être fermé par un substrat transparent, de façon à former une cuve pouvant recevoir une substance photopolymérisable solide, liquide ou gazeuse, les moyens d'éclairage permettant d'éclairer l'interface entre le substrat et la substance photopolymérisable en réflexion totale, de façon à former une zone d'évanescence au voisinage de cette interface.

L'invention sera illustrée par la description suivante, faite en référence aux exemples et aux dessins annexés dans lesquels :

- la Figure 1 est une représentation schématique du dispositif de l'invention ;
- la Figure 2 est une vue en perspective de la cuve mise en oeuvre dans le dispositif de l'invention.

Le procédé de fabrication d'un composant optique de l'invention consiste en la fabrication d'une couche mince de polymère, d'épaisseur micronique ou submicronique, à la surface d'un substrat transparent d'indice élevé $n_1$.

Le substrat transparent présente une face polie sur laquelle se formera la couche mince de polymère. Il peut être fabriqué en de nombreux matériaux vitreux d'indice élevé, par exemple en verre ordinaire, en pyrex (marque déposée), en silice fondue, en chlorure de sodium monocristallin, en fluorure de baryum monocristallin.... Son indice $n_1$ est de préférence supérieur à 1,35.

La formation de la couche mince de polymère est obtenue par mise au contact d'une face polie du substrat avec une substance photopolymérisable sous forme solide, liquide ou gazeuse, d'indice $n_2$.

Un faisceau lumineux éclaire la face polie du substrat au travers de celui-ci, sous un angle d'indice *i*, tel que $\frac{n_1}{n_2}$ sin *i* > 1, c'est-à-dire en réflexion totale, produisant ainsi une zone d'évanescence au voisinage de l'interface entre le substrat transparent et la substance photopolymérisable.

L'angle d'incidence i est choisi de telle sorte que la relation traduisant la réflexion totale soit assurée aussi bien après qu'avant polymérisation, l'indice $n_2$ changeant généralement entre ces deux états.

La substance photopolymérisable est composée d'un amorceur sensible à la lumière, apte à fournir des radicaux libres ou des cations et d'une résine photopolymérisable sous l'effet de ces radicaux libres ou cations.

La sensibilité en épaisseur de cette composition photopolymérisable est donnée par la loi de Beer-Lambert :

$$OD = \varepsilon \ c \ 1$$

où OD est la densité optique du matériau photopolymérisable avant polymérisation, c la concentration de l'amorceur, ε son coefficient d'absorption molaire et 1 le chemin optique parcouru par la lumière.

Une condition préférée connue en elle-même pour obtenir un amorçage efficace et, par conséquent, une gélification de la substance polymérisable, est donnée par $0,2 \leq OD \leq 1$.

Classiquement, pour un amorceur fonctionnant dans l'ultraviolet, $\varepsilon < 1500$ mol x $1^{-1}$ x $cm^{-1}$ et $c \leq 5$ %. Ces valeurs conduisent à des épaisseurs optiques sensibilisables de l'ordre de quelques dizaines de micromètres.

L'utilisation d'une sensibilisation de la substance photopolymérisable par un champ évanescent permet de contrôler l'épaisseur dans laquelle l'onde se propage et donc, l'épaisseur dans laquelle la substance photopolymérisable est sensibilisée.

Il est en effet connu par application de la théorie de l'optique ondulatoire qu'en réflexion totale, la pénétration de l'énergie dans le milieu d'indice faible, en fonction de la profondeur Z, est donnée par la formule

$$\frac{E}{E_0} = \exp(-\gamma z)$$

où E est l'énergie pénétrant dans le milieu à la profondeur Z, $E_0$ est l'énergie incidente et $\gamma$ facteur dépendant des indices $n_1$, $n_2$ de la longueur d'onde $\lambda$ et de l'angle d'incidence *i* selon la formule

$$\gamma = \frac{2\pi n_1}{\lambda}\sqrt{(\sin(i))^2 - \left(\frac{n_2}{n_1}\right)^2}$$

On comprend qu'ainsi, en agissant sur l'angle d'incidence *i*, il est possible de contrôler la profondeur de pénétration de la lumière et de la limiter éventuellement à une épaisseur inférieure au micromètre.

C'est la raison pour laquelle le procédé de fabrication de l'invention permet la réalisation de composants optiques définis avec une très haute résolution, aussi bien en surface (la taille du pixel est minimisée) qu'en épaisseur (taille du voxel).

Le dépôt, sur la face du substrat destinée à recevoir la couche de polymère, d'une couche transparente d'indice $n_3$ inférieur à $n_2$ permet de réaliser les conditions de la réflexion frustrée et d'introduire ainsi un moyen supplémentaire de contrôle de l'épaisseur de polymère déposé, celle-ci dépendant de la nature du matériau de la couche d'indice $n_3$ et de son épaisseur.

De nombreux moyens peuvent être mis en oeuvre pour réaliser des motifs dans la couche de polymère déposée.

On a vu que le faisceau lumineux incident peut être modulé spatialement par un masque, l'image de ce masque peut être formée dans la zone d'évanescence et il peut être éventuellement constitué par une vanne à cristaux liquides.

Il est également possible de mettre en oeuvre une méthode interférométrique pour définir la distribution spatiale de la lumière dans la zone d'évanescence.

Après la sensibilisation de la substance photopolymérisable par un faisceau lumineux, la couche photosensible subit un lavage, de façon à ce que les substances n'ayant pas réagi, ou n'étant pas suffisamment transformées, soient éliminées par un solvant approprié.

Le dispositif des Figures 1 et 2 a été mis en oeuvre pour la réalisation des procédés, objets des exemples.

Un statif métallique 1 est destiné à coopérer avec une lame de verre constituant le substrat transparent 2. Ils forment ensemble un parallélépipède ouvert, de manière à délimiter une cavité intérieure 3, elle-même parallélépipédique.

Le substrat transparent 2, d'indice n = 1,62, est lui-même parallélépipédique et disposé de telle sorte que sa face 4, formant une partie de la surface de la cavité intérieure 3, puisse être mise en contact avec une substance photopolymérisable liquide contenue par la cavité 3.

Un faisceau lumineux 6, approximativement parallèle, produit par exemple par un laser, est dirigé sur la face 4 du substrat 2 après que la cavité 3 ait été remplie d'une substance photopolymérisable.

L'angle d'incidence du faisceau laser 6 avec la surface 4 est déterminée en sorte que les conditions de la réflexion totale soient satisfaites.

Par ailleurs, cet angle d'incidence *i* est déterminé en fonction des indices $n_1$ du substrat 2 et $n_2$ de la substance photopolymérisable pour obtenir la profondeur de pénétration voulue du faisceau 6 dans le mélange photopolymérisable.

Un masque 7 assure la modulation spatiale du faisceau.

Ce dispositif a été mis en oeuvre dans les conditions suivantes. Les exemples 13 et 14 sont une illustration directe du procédé de l'invention, tandis que les autres exemples en facilitent l'exposé.

EXEMPLE 1

Le mélange liquide photopolymérisable placé dans la vue est formé de pentaérythritoltriacrylate (10 g), de méthyldiéthanolamine (900 mg) et d'éosine Y (340 mg). Un faisceau laser 6, de longueur d'onde $\lambda$ = 514 mm, produit par une source à argon ionisé, pénètre latéralement dans la lame 2, comme indiqué sur la Figure 1, en formant, avec la normale au plan d'incidence, un angle *i* de 70,3°. Ce faisceau, mis en forme par un dispositif optique adapté non représenté, présente un diamètre de 4 mm et sa puissance lumineuse est de 6,2 $mW/cm^2$. Ce faisceau produit le phénomène d'évanescence dans la région 5. Après 60 secondes d'illumination, la cuve est démontée et la lame de verre 1 est rincée avec de l'éthanol. Il subsiste, après cette opération, un film de polypentaérythritoltriacrylate, dont l'épaisseur mesurée par les techniques interférométriques classiques est estimée à 0,3 $\mu$m.

EXEMPLE 2

La formulation réactive est identique à celle de l'exemple 1. La puissance lumineuse du faisceau laser est de 5 $mW/cm^2$. Le temps d'irradiation et l'angle d'incidence sont inchangés. A l'issue de la phase d'illumination et après lavage, comme indiqué dans l'exemple précédent, l'épaisseur mesurée de la couche polymérisée est de 0,14 µm.

EXEMPLE 3

La formulation réactive, la puissance lumineuse et l'angle d'incidence sont identiques à ceux de l'exemple 1. Le temps d'illumination est porté à 30 secondes. A l'issue de la phase d'illumination et après lavage, comme indiqué dans l'exemple précédent, l'épaisseur mesurée de la couche polymérisée est de 0,19 µm.

EXEMPLE 4

La formulation réactive, la puissance lumineuse et le temps d'irradiation sont identiques à ceux de l'exemple 1. L'angle d'incidence est alors de 68,7°. A l'issue de la phase d'illumination et après lavage, comme indiqué dans l'exemple précédent, l'épaisseur mesurée de la couche polymérisée est de 0,4 µm.

EXEMPLE 5

La puissance lumineuse, le temps d'illumination et l'angle d'incidence sont identiques à ceux de l'exemple 1. Dans le mélange liquide polymérisable, décrit dans l'exemple 1, la quantité de méthyldiethanolamine est portée à 0,66 g. A l'issue de la phase d'illumination et après lavage, comme indiqué dans l'exemple précédent, l'épaisseur mesurée de la couche polymérisée est de 0,27 µm.

EXEMPLE 6

La puissance lumineuse, le temps d'illumination et l'angle d'incidence sont identiques à ceux de l'exemple 1. Dans le mélange liquide polymérisable, décrit dans l'exemple 1, la quantité d'éosine est portée à 0,13 g. A l'issue de la phase d'illumination et après lavage, comme indiqué dans l'exemple précédent, l'épaisseur mesurée de la couche polymérisée est de 0,1 µm.

EXEMPLE 7

La puissance lumineuse et l'angle d'incidence sont identiques à ceux de l'exemple 5. Le temps d'illumination est porté à 90 s. Dans le mélange liquide polymérisable, décrit dans l'exemple 1, l'éosine est remplacée par la phloxine en même proportion. A l'issue de la phase d'illumination et après lavage, comme indiqué dans l'exemple précédent, l'épaisseur mesurée de la couche polymérisée est de 0,05 µm environ.

EXEMPLE 8

La puissance lumineuse, le temps d'illumination et l'angle d'incidence sont identiques à ceux de l'exemple 1. Dans le mélange liquide polymérisable, décrit dans l'exemple 1, la méthyldiethanolamine est remplacée par la diméthyléthanolamine. A l'issue de la phase d'illumination et après lavage, comme indiqué dans l'exemple précédent, l'épaisseur mesurée de la couche polymérisée est de 0,16 µm.

EXEMPLE 9

La puissance lumineuse et l'angle d'incidence sont identiques à ceux de l'exemple 1. Le temps d'irradiation est porté à 90 s. Dans le mélange liquide polymérisable, décrit dans l'exemple 1, le pentaérythritoltriacrylate est remplacé par le triméthylolpropanetriacrylate. A l'issue de la phase d'illumination et après lavage, comme indiqué dans l'exemple précédent, l'épaisseur mesurée de la couche polymérisée est de 0,04 µm environ.

EXEMPLE 10

La puissance lumineuse, le temps d'illumination, l'angle d'incidence, ainsi que le mélange polymérisable, sont identiques à ceux de l'exemple 1. Un masque d'amplitude 7, analogue à ceux employés en microlithographie, est interposé sur le trajet du faisceau laser 6. Ce masque définit une alternance de zones opaques et transparentes avec

une périodicité spatiale de 5 traits/mm. A l'issue de la phase d'illumination et après lavage, comme indiqué dans l'exemple 1, on observe, sur la lame de verre dans la zone d'évanescence, une série de bandes de polymères de périodicité identique à celle des éléments du masque utilisé et d'épaisseur inférieure à 0,1 µm.

EXEMPLE 11

La puissance lumineuse, le temps d'illumination, l'angle d'incidence, ainsi que le mélange polymérisable, sont identiques à ceux de l'exemple 1. Dans cet exemple, une modulation spatiale de l'amplitude de l'onde évanescente est obtenue en créant, à l'aide d'un dispositif optique adapté, l'image d'un masque d'amplitude dans la zone d'évanescence. Le masque lui-même est placé sur le trajet du faisceau laser entre la source et la lame 2. A l'issue de la phase d'illumination et après lavage, comme indiqué dans l'exemple 1, on observe, sur la lame de verre dans la zone d'évanescence, une série de bandes de polymères de périodicité identique à celle des éléments du masque utilisé et d'épaisseur inférieure à 0,1 µm.

EXEMPLE 12

La puissance lumineuse, le temps d'illumination, l'angle d'incidence, ainsi que le mélange polymérisable, sont identiques à ceux de l'exemple 1. Dans cet exemple, le laser est réglé de telle façon qu'il émette à 488 nm au lieu de 514 nm, tel que décrit dans les exemples 1 à 11. A l'issue de la phase d'illumination et après lavage, comme indiqué dans l'exemple 1, on observe, sur la lame de verre, une couche de polymère d'épaisseur homogène égale à 0,04 µm.

EXEMPLE 13

La puissance lumineuse, le temps d'illumination, l'angle d'incidence, ainsi que le mélange polymérisable, sont identiques à ceux de l'exemple 1. Dans cet exemple, la lame de verre 2 subit, préalablement à la polymérisation, un traitement correspondant à la déposition d'une fine couche de silice cristalline de 0,2 µm sur l'interface au voisinage de laquelle se produit le phénomène d'évanescence. Dans ces conditions, l'épaisseur de la couche polymère obtenue est réduite à 0,1 µm, alors qu'en l'absence de cette microcouche intermédiaire (exemple 1), elle était de 0,3 µm.

EXEMPLE 14

La puissance lumineuse, le temps d'illumination, l'angle d'incidence, ainsi que le mélange polymérisable, sont identiques à ceux de l'exemple 1. La lame de verre 2 est traitée comme décrit dans l'exemple 13. La couche polymère obtenue est revêtue par évaporation sous vide d'une couche d'or de 50 nm. L'élément optique obtenu est un miroir dont les caractéristiques de réflexion sont définies uniquement par le pouvoir réflecteur du métal protecteur.

EXEMPLE 15

Un masque contenant un coin de densité est placé dans le trajet du faisceau laser. La formulation réactive est la même que dans l'exemple 6, l'angle est 69,2° et la puissance est 2,4 mW/cm$^2$ après le masque. Un microprisme de longueur 5 mm comportant une variation de l'épaisseur de 0 à 0,12 µm et de largeur 2 mm est obtenu.

Les formules développées des principaux composés utilisés dans les exemples sont les suivantes: Pentaerythritoltriacrylate (PETA) :

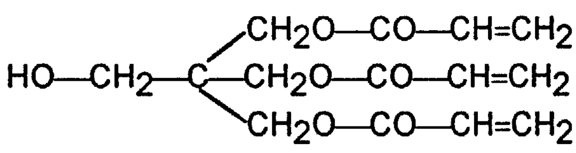

Methyldiethanolamine (MDEA) :

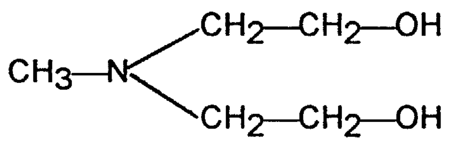

Eosine :

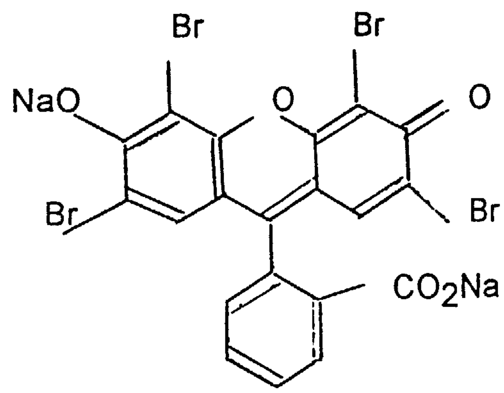

Ces différents exemples dans lesquels chaque paramètre et déterminant a été indépendamment modifié, font apparaître la possibilité de contrôler l'épaisseur de la couche par la puissance lumineuse de la source, par le temps d'illumination, par l'angle d'incidence du faisceau.
Cette épaisseur peut également être contrôlée par le choix de la composition du mélange polymérisable.
La présence d'un colorant sensibilisateur, la nature du donneur d'électron et la nature du monomère peuvent chacun être choisis parmi de nombreux composés sans affecter le principe de l'invention.
Il en est de même de la longueur d'onde.
L'intérêt et les effets produits par la mise en oeuvre d'un revêtement préalable de la lame de verre sont également démontrés.

## Revendications

1. Procédé de fabrication d'un composant optique dans lequel :

   on réalise un substrat,
   on dépose sur le substrat une substance photopolymérisable d'indice $n_2$,
   on éclaire la substance photopolymérisable au travers d'un milieu traversé d'indice élevé $n_1$ à l'aide d'un faisceau lumineux, sous un angle d'incidence *i*, tel que $n_1/n_2 \sin i > 1$ avant et après la polymérisation, produisant une zone d'évanescence au voisinage de l'interface entre les deux milieux,
   on traite la substance photopolymérisable de façon à révéler l'empreinte du faisceau lumineux,

   caractérisé en ce que le substrat réalisé est transparent, en ce que le faisceau lumineux éclaire la substance photopolymérisable au travers du substrat et en ce que le substrat est recouvert, sur sa face recevant la substance photopolymérisable, d'une couche solide transparente d'indice $n_3 < n_2$,

2. Procédé de fabrication d'un composant optique selon la revendication 1, caractérisé en ce que la substance photopolymérisable déposée sur le substrat forme, après polymérisation, une couche d'épaisseur comprise entre 0,01 et 5 micromètres.

3. Procédé selon l'une des revendications 1 et 2, caractérisé en ce que la substance photopolymérisable contient des molécules susceptibles de polymériser sous l'effet d'un amorçage par des radicaux libres ou des cations et

une substance capable sous l'effet de l'éclairement de générer transitoirement les radicaux libres ou les cations.

**4.** Procédé selon l'une quelconque des revendications 1 à 3, caractérisé en ce que lors de l'éclairement de la substance photopolymérisable, le faisceau lumineux possède une répartition d'amplitude obtenue par une technique interférométrique.

**5.** Procédé selon l'une quelconque des revendications 1 à 3, caractérisé en ce que lors de l'éclairement de la substance photopolymérisable, le faisceau lumineux est modulé spatialement, en amont de celle-ci par un masque.

**6.** Procédé selon la revendication 5, caractérisé en ce que lors de l'éclairement de la substance photopolymérisable, l'image du masque est formée dans la zone d'évanescence.

**7.** Procédé selon l'une quelconque des revendications 5 ou 6, caractérisé en ce que le masque est une valve à cristaux liquides.

**8.** Procédé selon l'une quelconque des revendications 1 à 7, caractérisé en ce que le substrat est en matériau vitreux d'indice n1 > 1,35.

**9.** Procédé selon l'une quelconque des revendications 3 à 8, caractérisé en ce que les molécules susceptibles de polymériser appartiennent à l'ensemble formé par les mono ou polyesters acryliques ou méthacryliques de polyols.

**10.** Procédé selon l'une quelconque des revendications 3 à 9, caractérisé en ce que la substance capable de générer transitoirement des radicaux libres ou des cations est un mélange de deux types de molécules utilisées en conjonction appartenant à l'ensemble formé de la benzophénone et ses dérivés, la diéthanolamine, l'acétophénone et ses dérivés, la diméthyléthanolamine.

**11.** Procédé selon l'une quelconque des revendications 3 à 10, caractérisé en ce que la substance capable de générer transitoirement des radicaux libres ou des cations comporte un colorant sensibilisateur.

**12.** Procédé selon la revendication 11, caractérisé en ce que le colorant sensibilisateur appartient à l'ensemble formé par l'éosine, l'érythrosine, le rose Bengale, le phénosafranine, le bleu de méthylène, la thionine, l'hexaméthylindotricarbocyanine.

**13.** Procédé selon l'une quelconque des revendications 3 à 9, caractérisé en ce que la substance capable de générer transitoirement des radicaux libres ou des cations appartient à l'ensemble formé par les éthers de benzoïne, les dérivés de phénylacétophénone et les acylphosphines oxydes et leurs dérivés.

**14.** Procédé selon l'une quelconque des revendications 1 à 13, caractérisé en ce que le composant optique assure le stockage d'information.

**15.** Dispositif de fabrication d'un composant optique selon une des revendications 1 à 14 comprenant :

des moyens d'éclairage par un faisceau lumineux,
des moyens de filtrage spatial du faisceau,

caractérisé en ce qu'il comporte un statif destiné à être fermé par un substrat transparent, de façon à former une cuve pouvant recevoir une substance photopolymérisable solide, liquide ou gazeuse, les moyens d'éclairage permettant d'éclairer l'interface entre le substrat et la substance photopolymérisable en réflexion totale, de façon à former une zone d'évanescence au voisinage de cette interface.

## Patentansprüche

**1.** Verfahren zum Herstellen eines optischen Bauelements, nach dem:

ein Substrat hergestellt wird,
auf das Substrat eine photopolymerisierbare Substanz mit einem Index $n_2$ aufgebracht wird,
die photopolymerisierbare Substanz beleuchtet wird durch ein Medium, durch das hindurch ein hoher Index

$n_1$ verläuft, mit Hilfe eines Lichtbündels unter einem Einfallswinkel *i*, wie beispielsweise $n_1/n_2$ sin *i* > 1 vor und nach der Polymerisation, welches eine gedämpfte Zone in der Nähe der Schnittstelle zwischen den beiden Medien erzeugt,
die photopolymerisierbare Substanz behandelt wird, um den Abdruck des Lichtbündels freizulegen,

dadurch gekennzeichnet,
dass das hergestellte Substrat transparent ist, dass das Lichtbündel die photopolymerisierbare Substanz durch das Substrat hindurch beleuchtet und dass das Substrat auf seiner Seite, die die photopolymerisierbare Substanz aufnimmt, mit einer festen transparenten Schicht mit einem Index $n_3 < n_2$ bedeckt wird.

**2.** Verfahren zur Herstellung eines optischen Bauelements nach Anspruch 1, dadurch gekennzeichnet, dass die photopolymerisierbare Substanz, die auf das Substrat aufgebrächt wird, nach der Polymerisierung eine Schicht mit einer Dicke zwischen 0,01 und 5 Mikrometer bildet.

**3.** Verfahren nach einem der Ansprüche 1 und 2, dadurch gekennzeichnet, dass die photopolymerisierbare Substanz Moleküle, die in der Lage sind, unter der Wirkung einer Anregung durch freie Radikale oder Kationen zu polymerisieren, und eine Substanz enthält, die in der Lage ist, unter der Wirkung der Beleuchtung vorübergehend die freien Radikale oder Kationen zu erzeugen.

**4.** Verfahren nach einem der Ansprüche 1 bis 3, dadurch gekennzeichnet, dass bei der Beleuchtung der photopolymerisierbaren Substanz das Lichtbündel eine Amplitudenverteilung besitzt, die durch eine interferometrische Technik erhalten wird.

**5.** Verfahren nach einem der Ansprüche 1 bis 3, dadurch gekennzeichnet, dass bei der Beleuchtung der photopolymerisierbaren Substanz das Lichtbündel im Vorlaufbereich derselben durch eine Maske räumlich moduliert wird.

**6.** Verfahren nach Anspruch 5, dadurch gekennzeichnet, dass bei der Beleuchtung der photopolymerisierbaren Substanz das Bild der Maske in der gedämpften Zone gebildet wird.

**7.** Verfahren nach einem der Ansprüche 5 oder 6, dadurch gekennzeichnet, dass die Maske ein Flüssigkristallventil ist.

**8.** Verfahren nach einem der Ansprüche 1 bis 7, dadurch gekennzeichnet, dass das Substrat aus einem glasartigen Material mit einem Index $n_1 > 1{,}35$ besteht.

**9.** Verfahren nach einem der Ansprüche 3 bis 8, dadurch gekennzeichnet, dass die Moleküle, die in der Lage sind zu polymerisieren, einer Einheit angehören, die aus Mono- oder Polyakrylestern oder aus Mono- oder Polymethakrylestern von Polyalkoholen gebildet wird.

**10.** Verfahren nach einem der Ansprüche 3 bis 9, dadurch gekennzeichnet, dass die Substanz, die in der Lage ist, vorübergehend freie Radikale oder Kationen zu erzeugen, ein Gemisch aus zwei Typen von Molekülen ist, die in Verbindung verwendet werden und der Einheit angehören, die aus Benzophenon und seinen Derivaten, Diäthanolamin, Azetophenon und seinen Derivaten und Dimethyläthanolamin gebildet wird.

**11.** Verfahren nach einem der Ansprüche 3 bis 10, dadurch gekennzeichnet, dass die Substanz, die in der Lage ist, vorübergehend freie Radikale oder Kationen zu bilden, einen Sensibilisierungsfarbstoff enthält.

**12.** Verfahren nach Anspruch 11, dadurch gekennzeichnet, dass der Sensibilisierungsfarbstoff einer Einheit angehört, die aus Eosin, Erythrosin, Bengalenrosa, Phenosafranin, Methylenblau, Thionin und Hexamethylindotrikarbozyanin gebildet wird.

**13.** Verfahren nach einem der Ansprüche 3 bis 9, dadurch gekennzeichnet, dass die Substanz, die in der Lage ist, vorübergehend freie Radikale und Kationen zu erzeugen, der Einheit angehört, die aus Benzoinäthern, den Derviaten von Phenylazetophenon und den Oxid-Acylphosphinen und ihren Derivaten gebildet wird.

**14.** Verfahren nach einem der Ansprüche 1 bis 13, dadurch gekennzeichnet, dass das optische Bauelement die Speicherung von Informationen gewährleistet.

**15.** Vorrichtung zum Herstellen eines optischen Bauelements nach einem der Ansprüche 1 bis 14, umfassend:

Beleuchtungsmittel durch ein Lichtbündel,
räumliche Filtermittel für das Bündel,

dadurch gekennzeichnet, dass sie ein Stativ umfasst, das dazu bestimmt ist, durch ein transparentes Substrat verschlossen zu werden, um eine Wanne zu bilden, die eine feste, flüssige oder gasförmige photopolymerisierbare Substanz aufnehmen kann, wobei es die Beleuchtungsmittel ermöglichen, die Schnittstelle zwischen dem Substrat und der photopolymerisierbaren Substanz in totaler Reflexion zu beleuchten, um eine gedämpfte Zone in Nähe dieser Schnittstelle zu bilden.

## Claims

**1.** A process for the manufacture of an optical component in which:

a substrate is made,
a photopolymerisable substance of index $n_2$ is applied onto the substrate,
the photopolymerisable substance is lit through an energised medium of high index $n_1$ using a luminous beam, from an angle of incidence *i*, such as $n_1/n_2 \sin i > 1$ before and after polymerisation, thereby generating a zone of evanescence close to the interface between both media,
the photopolymerisable substance is treated in order to expose the print of the luminous beam,

characterised in that the substrate obtained is transparent, in that the luminous beam lights up the photopolymerisable substance through the substrate and in that the substrate is coated, on its surface receiving the photopolymerisable substance, with a transparent solid layer of index $n_3 < n_2$.

**2.** A process for the manufacture of an optical component according to claim 1, characterised in that the photopolymerisable substance applied onto the substrate provides, after polymerisation, a layer of thickness between 0.01 and 5 microns.

**3.** A process according to one of the claims 1 and 2, characterised in that the photopolymerisable substance comprises molecules liable to polymerise under a priming effect by free radicals or cations and a substance capable, under the lighting effect, of generating transitorily the said free radicals or cations.

**4.** A process according to any one of claims 1 to 3, characterised in that when lighting up the photopolymerisable substance, the luminous beam shows an amplitude distribution obtained by an interferometric technique.

**5.** A process according to any one of claims 1 to 3, characterised in that when lighting up the photopolymerisable substance, the luminous beam is modulated spatially, upstream of the said photopolymerisable substance by a mask.

**6.** A process according to claim 5, characterised in that, when lighting up the photopolymerisable substance, the image of the mask is formed in the zone of evanescence.

**7.** A process according to any one of claims 5 or 6, characterised in that the mask is a liquid crystal valve.

**8.** A process according to any one of claims 1 to 7, characterised in that the substrate is made of a glassy material of index n1 > 1.35.

**9.** A process according to any one of claims 3 to 8, characterised in that the molecules liable to polymerise belong to the group formed by the polyol acrylic or methacrylic mono or polyesters.

**10.** A process according to any one of claims 3 to 9, characterised in that the substance capable of producing transitorily free radicals or cations is a mixture of both types of molecules used together and belonging to the group formed by benzophenone and its derivatives, diethanolamine, acetophenone and its derivatives, dimethylethanolamine.

**11.** A process according to any one of claims 3 to 10, characterised in that the substance capable of generating

transitorily free radicals or cations comprises a sensitising colouring agent.

**12.** A process according to claim 11, characterised in that the sensitising agent belongs to the group formed by eosine, erythrosine, Bengali pink, phenosafranine, methylene blue, thionine, hexamethylindotricarbocyanine.

**13.** A process according to any one of claims 3 to 9, characterised in that the substance capable of generating transitorily free radicals or cations belongs to the group formed by benzoin ethers, phenylacetophenone derivatives and acylphosphine oxides and their derivatives.

**14.** A process according to any one of claims 1 to 13, characterised in that the optical component enables information storage.

**15.** A device for the manufacture of an optical component according to any one of claims 1 to 14, comprising

lighting means through a luminous beam,
means for spatial filtering of the beam,

characterised in that it comprises a means intended to be closed by a transparent substrate, in order to build up a tank that may accommodate a solid, liquid or gaseous photopolymerisable substance, whereas the lighting means enable lighting the interface between the substrate and the photopolymerisable substance in total reflection, in order to form a zone of evanescence close to the said interface.

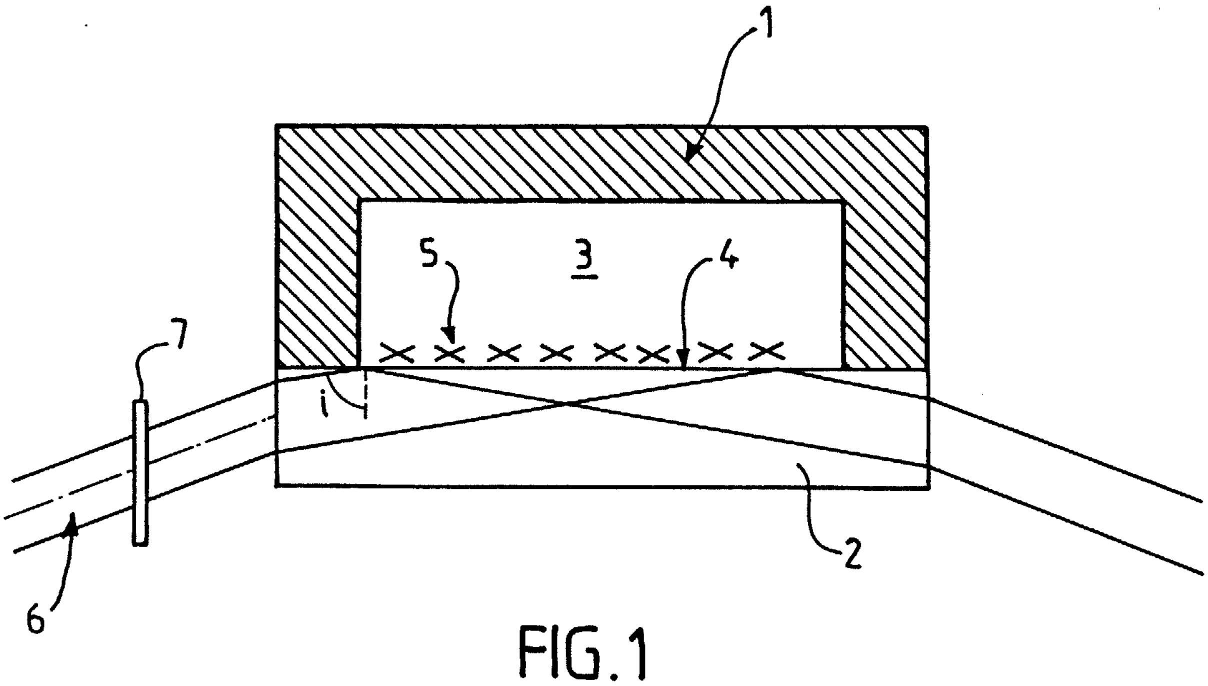


FIG.1

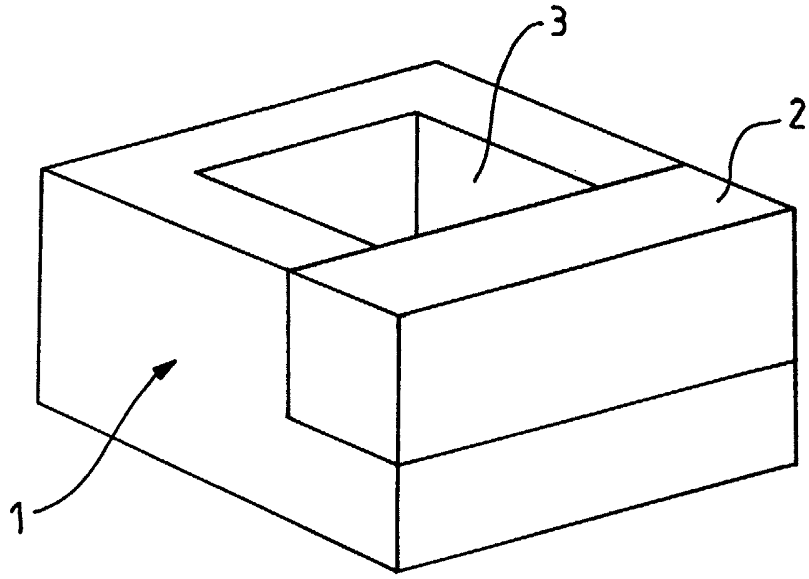


FIG. 2